(19) Europäisches Patentamt

European Patent Office

Office européen des brevets

(11) **EP 4 585 999 A1**

(12) **DEMANDE DE BREVET EUROPEEN**

(43) Date de publication:
**16.07.2025   Bulletin 2025/29**

(21) Numéro de dépôt: **25150820.6**

(22) Date de dépôt: **09.01.2025**

(51) Classification Internationale des Brevets (IPC):
*G02F 1/01* (2006.01)          *F21V 8/00* (2006.01)

(52) Classification Coopérative des Brevets (CPC):
**G02F 1/0128;** G02B 6/29341

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité:   **10.01.2024   FR 2400228**

(71) Demandeur: **Commissariat à l'Energie Atomique et aux Energies Alternatives**
**75015 Paris (FR)**

(72) Inventeurs:
- **FURCATTE, THOMAS**
  **38054 GRENOBLE CEDEX 09 (FR)**
- **SANSA PERNA, Marc**
  **38054 GRENOBLE CEDEX 09 (FR)**
- **HENTZ, Sébastien**
  **38054 GRENOBLE CEDEX 09 (FR)**

(74) Mandataire: **INNOV-GROUP**
**209 Avenue Berthelot**
**69007 Lyon (FR)**

(54)   **RÉSONATEUR COMPORTANT UN GUIDE DE LUMIÈRE PÉRIPHÉRIQUE DÉPORTÉ**

(57)   Résonateur (30) comportant :
- un actionneur (38)
- une structure résonante (31), configurée pour osciller, en se déformant périodiquement selon une fréquence de résonance ($f_r$), sous l'effet de l'actionneur ;
- un guide de lumière périphérique (32), s'étendant autour de la structure résonante, et configuré pour osciller, en se déformant périodiquement, en étant entraîné par la structure résonante ;
le résonateur étant caractérisé en ce que:
- la structure résonante (31) est plus épaisse que le guide de lumière périphérique ;
- le guide de lumière périphérique est maintenu à distance de la structure résonante par au moins un ancrage (33).

**Fig. 3A**

EP 4 585 999 A1

**Description**

## DOMAINE TECHNIQUE

Le domaine technique de l'invention concerne les résonateurs mécaniques, pouvant notamment être utilisés pour former un oscillateur opto-mécanique.

## ART ANTERIEUR

Le recours à un oscillateur opto-mécanique permet une formation d'un signal électronique périodique dont l'amplitude et la période sont maîtrisées. Une application possible est la formation d'un signal d'horloge.

Dans les dispositifs de l'art antérieur, les oscillateurs opto-mécaniques comportent une source de lumière et un résonateur. Sous l'effet du couplage optique, une partie de la lumière émise par la source de lumière est extraite et se propage dans le résonateur. Lorsque la structure résonante oscille, à une fréquence de résonance, l'efficacité du couplage optique à une longueur d'onde donnée varie à la fréquence de résonance. Il en résulte une variation périodique de la quantité de lumière extraite dans le résonateur.

En règle générale, dans les dispositifs optomécaniques, l'épaisseur des structures est bornée à quelques centaines de nanomètres de manière à maintenir un seul mode de propagation optique. Par simplicité, le résonateur est usuellement extrait d'une unique couche d'épaisseur fixe. La raison est de limiter les risques de couplage intermodal, qui détruit l'utilisation pratique.

Lorsque ces résonateurs sont insérés dans des oscillateurs, ces restrictions d'épaisseur empêchent l'oscillateur d'être performant. Ces performances sont quantifiées grâce à une figure de mérite, appelée bruit de phase de l'oscillateur, qui doit être minimisée. Le bruit de phase dépend notamment du « pouvoir filtrant » du résonateur, c'est-à-dire son facteur de qualité mécanique (à maximiser), que l'on peut augmenter via un épaississement du résonateur.

La publication Beyazoglu et al « A multimaterial Q-boosted low phase noise optomechanical oscillator", décrit un oscillateur optomécanique présentant un faible niveau de bruit. L'oscillateur comporte un anneau en silicium polycristallin entouré par un anneau de nitrure de silicium, formant un guide de lumière périphérique. Les deux anneaux sont concentriques. L'anneau de silicium polycristallin forme une structure résonante, mise en vibration par des électrodes, par effet capacitif. La vibration de la structure résonante entraîne un déplacement du guide de lumière périphérique. L'anneau formant le guide de lumière est plus fin que l'anneau formant la structure résonante. Deux matériaux différents sont utilisés pour former respectivement la structure résonante, mise en vibration par des électrodes, et le guide de lumière périphérique. Le guide de lumière périphérique s'étend au contact de la structure résonante, tout autour de cette dernière. Afin de permettre un confinement de la lumière, le guide de lumière doit avoir une certaine largeur.

US2018224606 décrit une structure résonante annulaire, formée par deux électrodes autour de laquelle s'étend une cavité optique circulaire, formant un guide de lumière périphérique. La structure résonante s'étend autour d'un socle épais. La structure résonante a sensiblement la même épaisseur que le guide de lumière périphérique.

US2019101488 décrit un résonateur comportant un canal fluidique et un guide d'onde. Le guide d'onde est utilisé pour permettre une détection d'une variation, notamment de masse, du fluide circulant dans le canal fluidique. Le guide d'onde est intégré dans le résonateur.

US2022334314 décrit un résonateur électromécanique destiné à convertir une excitation mécanique d'une poutrelle en modulation des propriétés d'un guide d'onde optique annulaire. Le guide d'onde annulaire est plus épais que la poutrelle.

Les inventeurs proposent un résonateur optomécanique disposant d'un facteur de qualité mécanique élevé tout limitant le nombre de modes optiques . Il présente également une sensibilité réduite aux fluctuations de température, faisant de lui un candidat idéal pour être utilisé au sein d'oscillateurs. L'objectif peut être de générer un signal modulé en amplitude dont la puissance et la période sont stables.

## EXPOSE DE L'INVENTION

Un premier objet de l'invention est un résonateur comportant :

- un actionneur ;
- une structure résonante, configurée pour osciller, en se déformant périodiquement selon une fréquence de résonance, sous l'effet de l'actionneur ;
- un guide de lumière périphérique, s'étendant autour de la structure résonante, et configuré pour osciller, en se déformant périodiquement, en étant entraîné par la structure résonante ;

le résonateur étant caractérisé en ce que:

- la structure résonante est plus épaisse que le guide de lumière périphérique ;
- le guide de lumière périphérique est maintenu à distance de la structure résonante par au moins un ancrage.

Un espace intermédiaire peut notamment s'étendre entre le guide de lumière périphérique et la structure résonante, l'espace intermédiaire étant rempli par un gaz ou un liquide ou du vide. Selon une possibilité :

- l'épaisseur du guide de lumière périphérique est comprise entre 100 nm et 600 nm ;
- l'épaisseur de la structure résonante est au moins deux fois ou au moins trois fois supérieure à l'épaisseur du guide de lumière périphérique.

L'épaisseur de la structure résonante peut être comprise entre 600 nm et 1 mm, et de préférence entre 1 μm et 50 μm.

La structure résonante peut être disposée en vis-à-vis d'au moins une électrode d'actionnement, l'électrode d'actionnement étant espacée de la structure résonante par un entrefer, l'électrode d'actionnement formant l'actionneur, en étant configurée pour engendrer une oscillation de la structure résonante par exemple par effet capacitif.

L'électrode d'actionnement peut s'étendre dans l'espace intermédiaire.

Selon une possibilité :

- la structure résonante comporte un matériau piézoélectrique ;
- le résonateur comporte deux électrodes d'actionnement, de part et d'autre de la structure résonante, les électrodes d'actionnement formant l'actionneur.

La structure résonante et le guide d'onde périphérique peuvent être formés du même matériau. La structure résonante peut avoir une forme cylindrique, à base circulaire ou polygonale, ou annulaire.

La fréquence de résonance peut être supérieure à 1 MHz.

Un deuxième objet de l'invention est un oscillateur opto-mécanique, comportant :

- une source de lumière, configurée pour émettre un faisceau lumineux et propager ce dernier le long d'un résonateur ;
- le résonateur étant configuré de façon que l'oscillation périodique du résonateur entraîne une modulation périodique d'une puissance lumineuse du faisceau de lumineux.
- l'oscillateur opto-mécanique étant caractérisé en ce que le résonateur est un résonateur selon le premier objet de l'invention.

L'oscillateur peut comporter un photodétecteur, configuré pour détecter le faisceau lumineux s'étant propagé le long du résonateur. Le photodétecteur peut être configuré pour alimenter le résonateur par un signal de rétroaction.

L'invention sera mieux comprise à la lecture de l'exposé des exemples de réalisation présentés, dans la suite de la description, en lien avec les figures listées ci-dessous.

## FIGURES

La figure 1A et la figure 1B schématisent les principaux composants d'un oscillateur optomécanique.

La figure 2 illustre une oscillation de la puissance optique délivrée par un oscillateur optomécanique tel que décrit en lien avec les figures 1A et 1B

La figure 3A est une vue tridimensionnelle schématisant une structure résonante entraînant un guide de lumière périphérique selon un mouvement d'oscillation

La figure 3B schématise une vue en coupe de la structure résonante et du guide de lumière périphérique décrits en lien avec la figure 3A. Le plan de coupe correspondant à un plan médian du guide de lumière périphérique.

La figure 3C montre une vue en coupe de la structure résonante décrite en lien avec la figure 3B, dans un plan de coupe transversal, perpendiculaire au plan médian du guide de lumière périphérique.

La figure 3D représente la configuration décrite en lien avec les figures 3A à 3C avec un actionneur par effet capacitif.

La figure 4 illustre la répartition du champ électromagnétique dans un guide de lumière cylindrique d'épaisseur 1 μm , multimode selon l'axe vertical, et à symétrie cylindrique.

La figure 5A schématise un deuxième mode de réalisation de l'invention, dans un plan de coupe transversal tel que précédemment défini.

La figure 5B schématise le deuxième mode de réalisation de l'invention, dans un plan de coupe correspondant au plan médian du guide de lumière périphérique.

Les figures 6A à 6I schématisent un procédé de réalisation du résonateur tel que décrit en lien avec la figure 3D.

La figure 7 montre un troisième mode de réalisation, dans lequel l'actionnement de la structure résonante est effectuée par effet piézoélectrique.

## EXPOSE DE MODES DE REALISATION PARTICULIERS

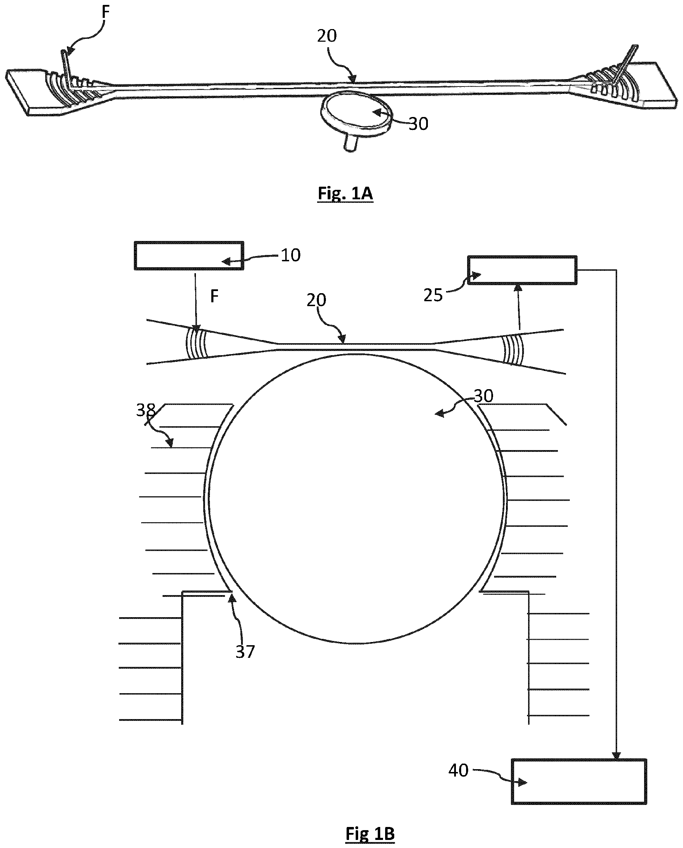

Les figures 1A et 1B schématise des composants d'un oscillateur optomécanique. L'oscillateur comporte une source de lumière 10, émettant un faisceau de lumière F. Dans cet exemple, le faisceau de lumière est transporté par un guide de lumière 20 jusqu'à un photodétecteur 25.

L'oscillateur comporte un résonateur 30 s'étendant le long du guide de lumière 20. Le résonateur 30 est configuré pour osciller, en se déformant, à une fréquence de résonance $f_r$. La fréquence de résonance est de préférence supérieure à 1 MHz, et est de préférence comprise dans la plage 1 MHz - 100 GHz. Le résonateur est, dans cet exemple, configuré pour être animé d'un mouvement de vibration dans le plan, selon la fréquence de résonance, sous l'effet d'un actionnement capacitif exercé par un actionneur 38. L'actionneur 38, représenté sur la figure 1B, est fixe par rapport au résonateur 30. L'actionneur 38 est situé de part et d'autre du résonateur 30. L'actionnement électrostatique est effectué à travers un entrefer 37, s'étendant entre l'actionneur fixe 38 et le résonateur 30. L'actionnement capacitif est commandé par une unité de commande 40.

Le photodétecteur est configuré pour former un signal électrique modulé selon une fréquence de modulation, à la fréquence de résonance du résonateur. Le signal modulé en fréquence peut être utilisé pour former un signal d'horloge. L'unité de commande 40 est alimentée par une boucle de rétroaction résultant du photodétecteur 25.

Dans cet exemple, le résonateur 30 est un cylindre à base circulaire. Le résonateur peut s'étendre selon une géométrie différente, par exemple un cylindre à base polygonale ou un anneau.

Le guide de lumière 20 peut être réalisé sur la couche de Si superficielle d'un substrat de type SOI (silicon on Insulator - silicium sur isolant). La section transversale peut par exemple être de quelques centaines de nm par quelques centaines de nm, par exemple de l'ordre de 600 nm x 200 nm. Par section transversale, on entend une section dans un plan perpendiculaire à l'axe de propagation de la lumière. De préférence, le guide de lumière 20 est configuré pour effectuer une propagation selon un seul mode, à une longueur d'onde qui peut être 1550 nm, longueur d'onde usuelle dans le domaine des télécommunications.

Le résonateur 30 est optiquement couplé au guide de lumière 20, par exemple par couplage évanescent. La distance entre le résonateur et le guide de lumière 20 est par exemple de 100 nm. Ainsi, lorsqu'un faisceau lumineux se propage le long du guide de lumière 20, une partie du faisceau lumineux est extraite et se propage dans le résonateur 30.

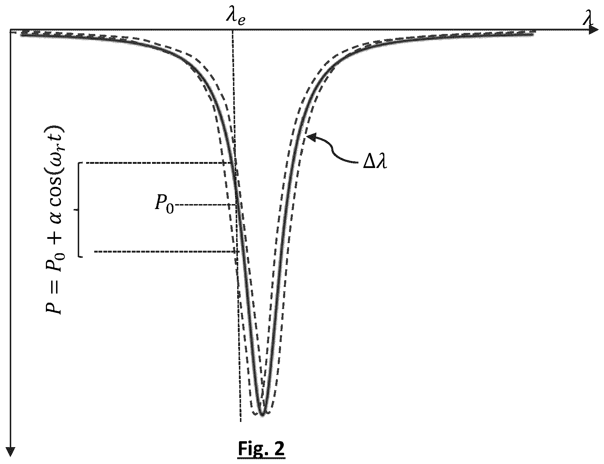

La figure 2 illustre une bande passante de couplage optique entre le guide de lumière 20 et le résonateur 30. L'axe des abscisses correspond à la longueur d'onde optique. L'axe des ordonnées correspond à la puissance lumineuse extraite du guide de lumière optique 20 par le résonateur 30. La courbe en trait plein représente la configuration fixe, selon laquelle le résonateur est fixe. Sous l'effet de l'oscillation du résonateur, le couplage optique ente le guide d'onde et le résonateur varie. Sur la figure 2, cela se traduit par une variation périodique de la bande passante de couplage, entre les deux courbes en tirets, traduisant un décalage spectral du couplage guide de lumière 20 / résonateur 30.

Sur la figure 2, la ligne verticale en pointillés correspond à la longueur d'onde d'émission $\lambda_e$ du faisceau F se propageant dans le guide de lumière 20. Sous l'effet de la variation périodique de la bande passante de couplage, la puissance du faisceau optique F se propageant dans le guide de lumière 20 est modulée selon une pulsation $\omega_r$, selon l'expression

$$P = P_0 + \alpha \cos(\omega_r t) \; (1)$$

où :

- $P_0$ correspond à la puissance se propageant dans le guide de lumière « à l'équilibre », c'est-à-dire en l'absence d'oscillation du guide de lumière périphérique 32 ;
- $\alpha$ correspond l'amplitude de modulation, c'est-à-dire la variation de puissance extraite dans le guide de lumière périphérique 32 sous l'effet de l'oscillation de la structure résonante 31.
- $\omega_r = 2\pi f_r$ (2)

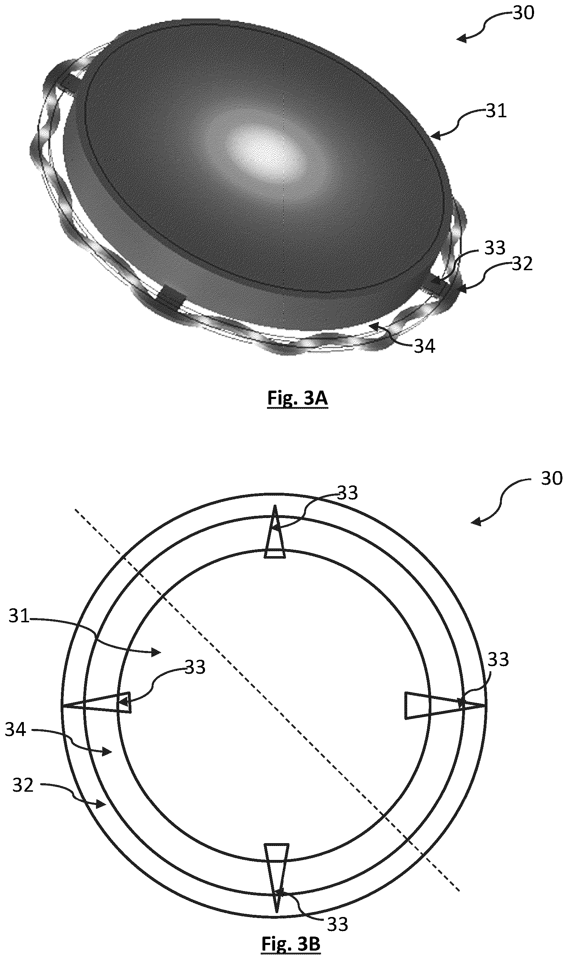

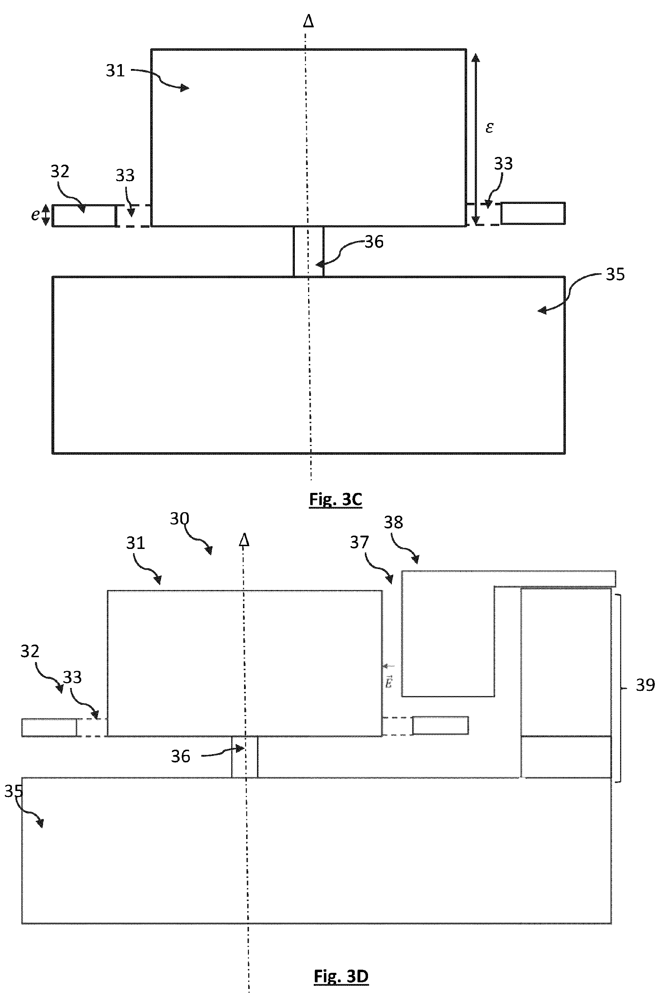

Les figures 3A à 3D représentent un exemple de résonateur 30 selon l'invention, pouvant être intégré dans un oscillateur tel que décrit en lien avec les figures 1A et 1B. La figure 3A correspond à une vue en perspective. Les figures 3B et 3D sont des vues en coupe.

Une particularité du résonateur est que le facteur de qualité mécanique est élevé, tandis que la sensibilité à des fluctuations de température est réduite.

Lorsqu'il est partie prenante d'un oscillateur, le résonateur 30 agit comme un filtre passe-bande, atténuant les sources de bruit dont les composantes fréquentielles sont situées hors de la bande passante du résonateur. La largeur de cette bande passante est inversement proportionnelle au facteur de qualité mécanique, ainsi le mouvement oscillant du résonateur aura une meilleure pureté spectrale si il bénéficie de hauts facteurs de qualité. La modulation du faisceau optique, effectuée par le système de transduction optomécanique, bénéficie également de cette pureté spectrale améliorée. Il est donc important de disposer d'un facteur de qualité mécanique Q élevé. Plus l'épaisseur d'un résonateur mécanique augmente, plus le facteur de qualité augmente.

Le facteur de qualité mécanique du résonateur correspond à la finesse du pic du résonance de l'oscillation du résonateur. Lorsque le résonateur est inséré dans un oscillateur, la figure de mérite de ce dernier, également appelée le bruit de phase, doit être minimisée. Il est possible de montrer que le bruit de phase dépend du ratio $1/Q^2$, Q étant le facteur de qualité mécanique. L'intérêt est donc ici de travailler avec des facteurs de qualité mécaniques le plus élevés possible Il est également considéré que la densité spectrale du bruit comporte une composante thermique pouvant être considérée comme inversement proportionnelle à la masse du résonateur, donc à son épaisseur.

Ainsi, afin d'augmenter le facteur de qualité mécanique et diminuer la sensibilité au bruit, il est préférable d'augmenter l'épaisseur du résonateur 30. Toutefois, il est préférable que la lumière se propage à travers une structure dont l'épaisseur soit suffisamment faible de manière à n'autoriser qu'une propagation de lumière monomode dans la section transversale du guide.

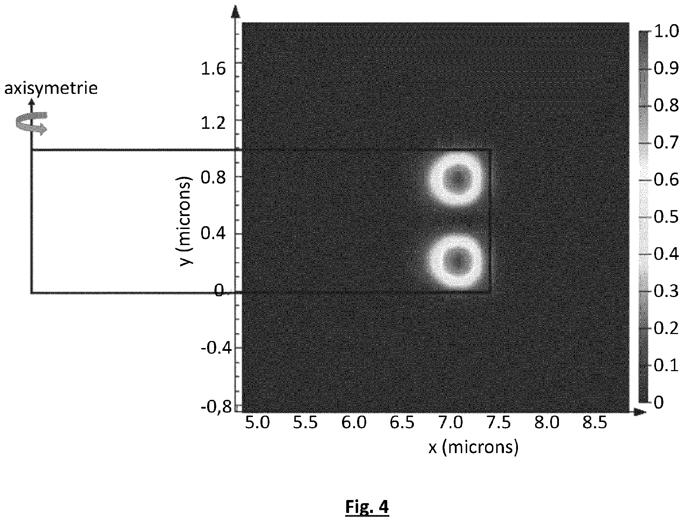

Sur la figure 4, on a représenté une vue en coupe d'un guide de lumière, présentant une épaisseur de 1 μm. On a représenté, une distribution spatiale de l'intensité d'un champ électrique dans la section transversale du guide de lumière. Les niveaux de gris représentent l'intensité du champ électrique. On observe, dans chaque section transversale, deux maxima : cela traduit le fait que la lumière se propage selon plusieurs modes, ce qui n'est pas souhaitable, du fait de risque de couplage intermodal.

Le résonateur 30, représenté sur les figures 3A à 3D, comporte une structure résonante 31, configurée pour être mise en vibration par un actionneur. Le résonateur comporte également un guide de lumière périphérique 32, s'étendant autour de la structure résonante, à une distance non nulle de cette dernière. Des ancrages 33 relient le guide de lumière périphérique 32 à la structure résonante 31. Comme représenté sur la figure 3B, les ancrages sont disposés de façon à transmettre les oscillations de la structure résonnante 31 au guide de lumière périphérique 32, tout en maintenant le guide de lumière périphérique 32 éloigné de la structure résonante 31.

Sur la figure 3A, le guide de lumière périphérique est représenté :

- en ombré, lorsqu'il est animé d'un mouvement d'oscillation transmis par les ancrages 33;
- en filaire, à l'état immobile : il décrit alors un anneau autour de la structure résonnante 32.

Un espace intermédiaire 34 s'étend entre le guide de lumière périphérique 32 et la structure résonante 31. L'espace intermédiaire 34 s'étend autour de la structure résonante 31, entre chaque ancrage 33. Ainsi, le long d'au moins 80%, voire 90% du contour du guide de lumière périphérique 32, ce dernier est séparé de la structure résonante 31 par l'espace intermédiaire 34. L'espace intermédiaire 34 est rempli par le milieu ambiant : il peut s'agir d'un gaz, tel de l'air, ou de vide ou d'un liquide dont l'indice de réfraction est inférieur à celui du matériau formant le guide de lumière périphérique.

La figure 3B montre une vue en coupe des éléments schématisés sur la figure 3A, dans un plan de coupe correspondant à un plan médian du guide de lumière périphérique 32.

L'éloignement du guide de lumière périphérique 32 vis-à-vis de la structure résonante 31 permet de confiner la lumière se propageant dans le guide de lumière périphérique. Ainsi, la structure résonante 31 et le guide de lumière périphérique 32 peuvent être formés d'un même matériau, par exemple Si. Les ancrages 33 peuvent être formés du même matériau, l'effet des ancrages sur le confinement de la lumière étant négligeable du fait de leur faible surface de contact avec le contour du guide de lumière périphérique : typiquement moins de 20%, voire moins de 10%, voire moins de 5% du contour du guide de lumière périphérique, en vis-à-vis de la structure résonante 31, est occupé par un ancrage.

La figure 3C montre un plan de coupe selon l'épaisseur d'une partie du résonateur, le long d'une ligne représentée en tirets sur la figure 3B. La structure résonante 31, mise en mouvement par un actionneur, s'étend selon une épaisseur $\varepsilon$ de préférence comprise entre 600 nm et 1 mm, et encore de préférence comprise entre 1 μm et 50 μm. L'épaisseur e du guide de lumière périphérique 32 est de préférence comprise entre 50 nm et 600 nm, ou entre 100 nm et 600 nm, par exemple 200 nm. D'une façon générale, l'épaisseur de la structure résonante 31 est au moins deux fois ou au moins trois fois supérieure à l'épaisseur du guide de lumière périphérique 32.

La structure résonante 31 est reliée à un socle 35 par un pilier 36. La structure résonante 31, de même que le guide de lumière périphérique 32, s'étendent autour d'un axe central Δ. Durant les oscillations de la structure résonnante 31, l'axe central Δ reste fixe. L'axe central Δ forme de préférence un axe de symétrie de l'ensemble formé par la structure résonante 31 et le guide de lumière périphérique 32. Sur la figure 3C, les ancrages 33 ont été matérialisés par des tirets.

Sur la figure 3D, on a représenté une électrode d'actionnement 38, permettant un actionnement de la structure résonante par effet capacitif. L'électrode d'actionnement fait office d'actionneur. Un entrefer isolant 37 s'étend entre l'électrode d'actuation 38 et la structure résonante 31. L'actuateur est formé par une électrode polarisée par un courant alternatif générant un champ électrique $\vec{E}$ dans l'entrefer. L'épaisseur de l'entrefer est de l'ordre de la centaine de nm. De préférence, l'entrefer 37 est comblé par le milieu ambiant : gaz, vide ou liquide. L'électrode d'actionnement est maintenue par un support 39, ce dernier étant relié au socle 35. Sur la figure 3D, on a représenté, par des tirets, les ancrages 33, ces derniers étant répartis, de préférence de façon symétrique par rapport à l'axe Δ, entre le guide de lumière périphérique 32 et la structure résonante 31.

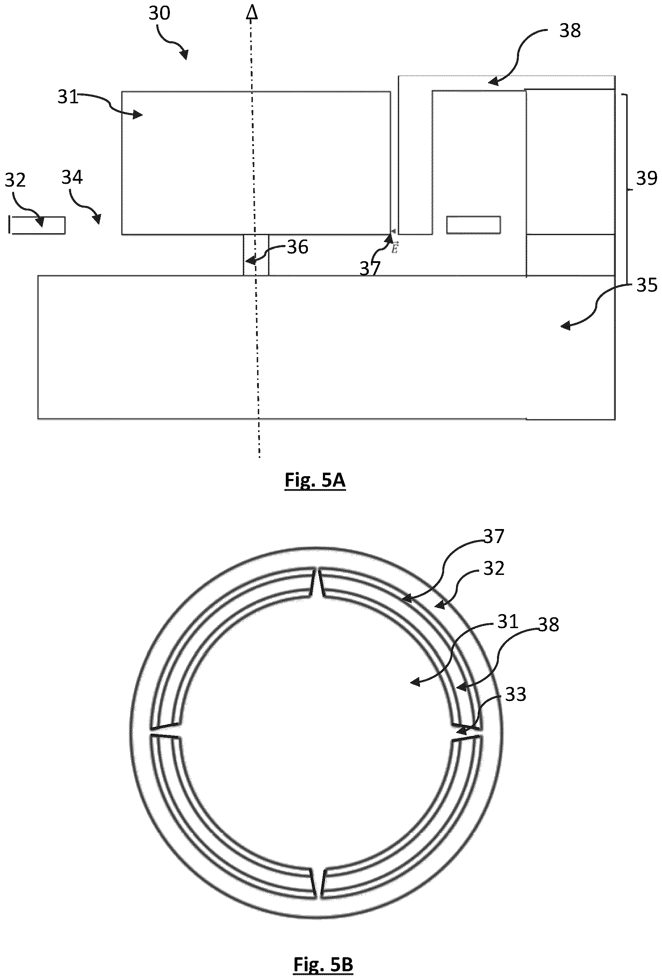

Les figures 5A et 5B représentent un mode de réalisation selon lequel l'électrode d'actionnement 38 s'étend entre la structure résonante 31 et le guide de lumière périphérique 32. Les figures 5A et 5B sont respectivement des coupes dans le plan transversal et dans le plan médian tels que précédemment définis. Un tel mode de réalisation augmente la surface selon laquelle est effectué le couplage capacitif entre l'électrode 38 et la structure résonante 31. Il en résulte un meilleur couplage entre l'électrode d'actionnement 38 et la structure résonante 31. L'entrefer 37 correspond alors à une partie de l'espace intermédiaire 34 s'étendant entre la structure résonante 31 et le guide de lumière périphérique 32.

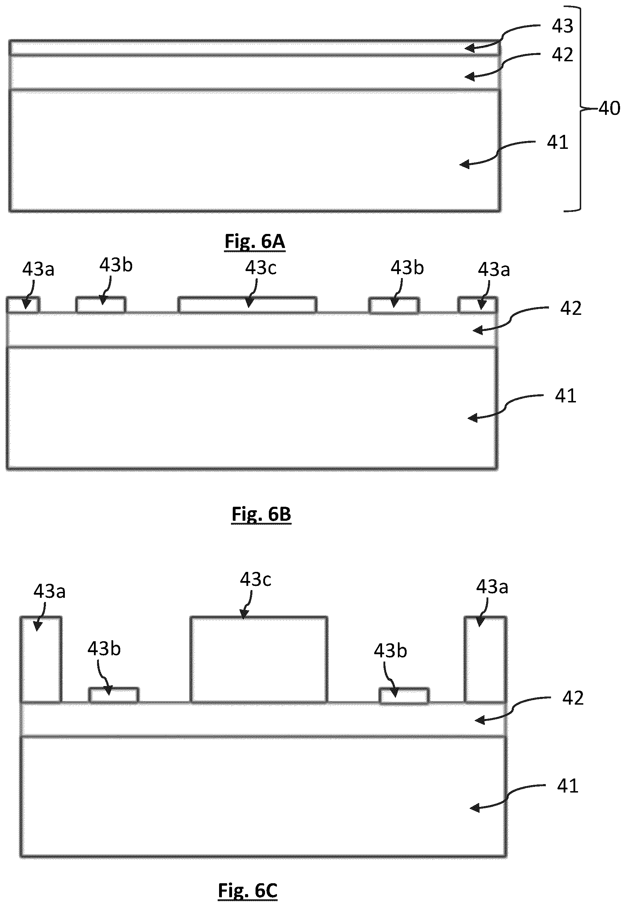

Les figures 6A à 6I schématisent les principale étapes d'un procédé de fabrication d'un résonateur 30 tel que décrit en lien avec la figure 3D. On dispose d'un substrat 40 de type SOI, comportant une superposition d'une couche bulk 41, d'une couche intermédiaire 42 de SiO2 et d'une couche supérieure 43 de Si amincie, l'épaisseur de cette dernière étant par exemple 220 nm. Cf. figure 6A.

La couche supérieure 43 fait l'objet d'une gravure, de façon à définir plusieurs éléments : cf. figure 6B. Un élément périphérique, annulaire, 43a, forme une base d'un support de l'électrode d'actionnement. Un élément central 43c, cylindrique, correspond à une base de la structure résonante. Un élément annulaire 43b forme le guide de lumière périphérique et, localement, les ancrages, ces derniers s'étendant entre l'élément central 43c et l'élément périphérique annulaire 43a.

L'élément central 43c et l'élément 43a font l'objet d'une croissance par épitaxie. Cf. figure 6C.

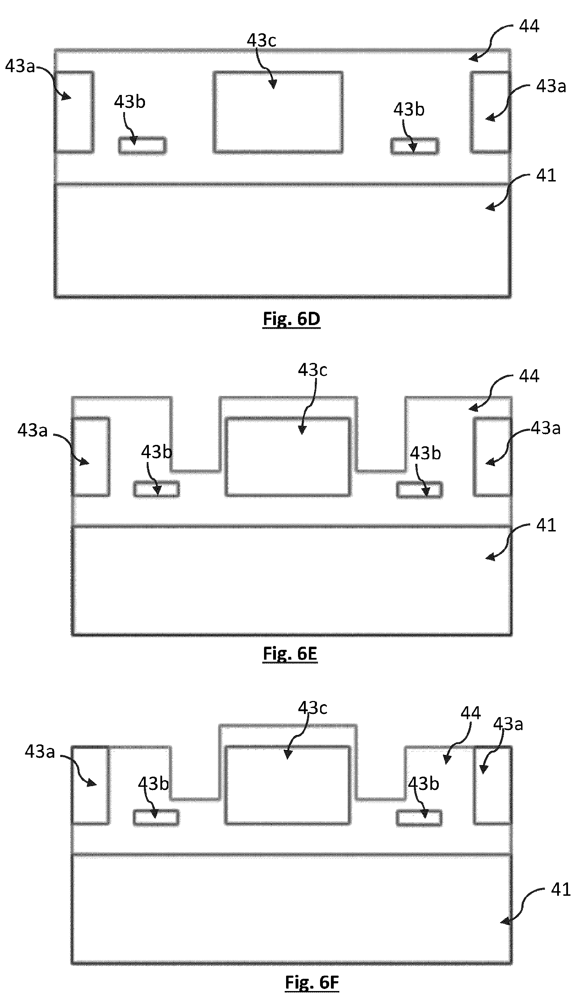

Une couche 44 de $SiO_2$ est déposée : cf. figure 6D, puis fait l'objet d'une gravure profonde, de façon à délimiter l'élément central 43c : cf. figure 6E. Une gravure superficielle est appliquée, de façon à libérer la surface supérieure de l'empilement, autour de l'élément central. Cf. figure 6F.

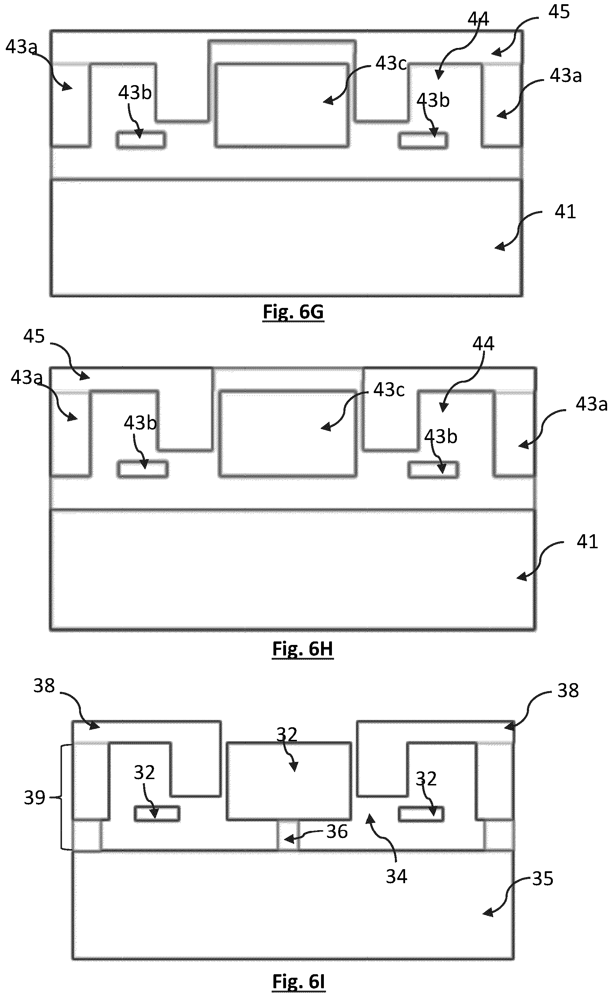

Une couche conductrice 45, par exemple métallique, est appliquée au niveau de la surface supérieure de l'empilement : cf. figure 6G. La couche conductrice 45 fait ensuite l'objet d'un amincissement : cf. figure 6H. Une gravure humide permet ensuite d'éliminer le SiO2 44, en laissant subsister des résidus destinés à former un pilier 36 ainsi qu'une partie du support 39. Voir figure 6I. Sur la figure 6I, on distingue les principaux éléments formant le résonateur 30 tel que décrit en lien avec la figure 3D.

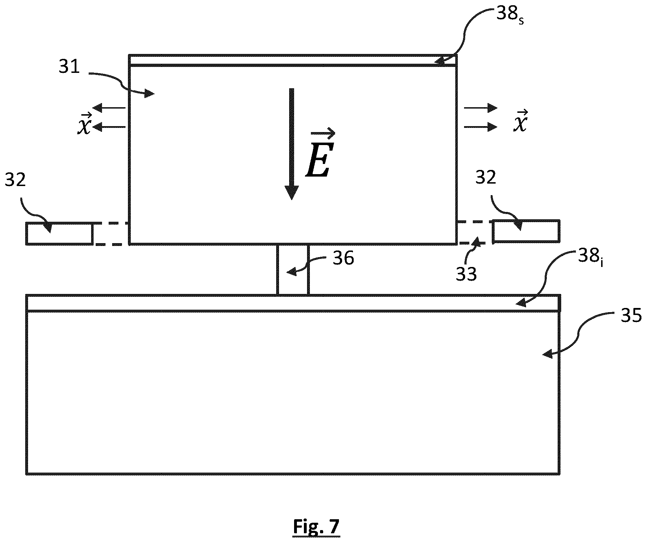

La figure 7 représente un troisième mode de réalisation, dans lequel l'actionnement de la structure résonante 31 est piézoélectrique. Les éléments 32, 35 et 36 sont tels que décrits en lien avec les figures 4D ou 5A. La structure résonante est formée d'un matériau piézoélectrique, par exemple nitrure d'aluminium (AIN), niobate de lithium (LNO). Le socle 35 comporte une électrode inférieure $38_i$. La structure résonante comporte une électrode supérieure $38_s$. Sous l'effet d'un champ électrique modulé en amplitude $\vec{E}$ entre l'électrode supérieure $38_s$ et l'électrode inférieure $38_i$, la structure résonante se déforme, selon un vecteur $\vec{x}$ tel que représenté sur la figure 7. Les électrodes peuvent être formées de métal, d'alliage métallique, ou de semi-conducteur dopé.

L'invention permet de former un résonateur configuré pour moduler un faisceau lumineux en amplitude de façon stable, et selon une fréquence stabilisée. Lorsqu'un tel résonateur est intégré à un oscillateur, cela permet de former un signal d'horloge dont l'amplitude et la fréquence sont maîtrisées.

## Revendications

**1.** Résonateur (30) comportant :

- un actionneur (38)
- une structure résonante (31), configurée pour osciller, en se déformant périodiquement selon une fréquence de résonance ($f_r$), sous l'effet de l'actionneur ;
- un guide de lumière périphérique (32), s'étendant autour de la structure résonante, et configuré pour osciller, en se déformant périodiquement, en étant entraîné par la structure résonante ;

le résonateur étant **caractérisé en ce que**:

- la structure résonante (31) est plus épaisse que le guide de lumière périphérique ;
- le guide de lumière périphérique est maintenu à distance de la structure résonante par au moins un ancrage (33) ;
- un espace intermédiaire (34) s'étend entre le guide de lumière périphérique (32) et la structure résonante (31), l'espace intermédiaire étant rempli par un gaz ou un liquide ou du vide.

**2.** Résonateur selon la revendication 1, dans lequel :

- l'épaisseur du guide de lumière périphérique est comprise entre 100 nm et 600 nm ;
- l'épaisseur de la structure résonante est au moins deux fois ou au moins trois fois supérieure à l'épaisseur du guide de lumière périphérique.

**3.** Résonateur selon la revendication 2, dans lequel l'épaisseur de la structure résonante est comprise entre 600 nm et 1 mm.

**4.** Résonateur selon l'une quelconque des revendications précédentes, dans lequel l'épaisseur de la structure résonante est comprise entre 1 μm et 50 μm.

**5.** Résonateur selon l'une quelconque des revendications précédentes, dans lequel la structure résonante est disposée en vis-à-vis d'au moins une électrode d'actionnement (38), l'électrode d'actionnement étant espacée de la structure résonante par un entrefer (37), l'électrode d'actionnement formant l'actionneur, en étant configurée pour engendrer une oscillation de la structure résonante par effet capacitif.

**6.** Résonateur selon l'une quelconque des revendications précédentes, dans lequel l'électrode s'étend dans l'espace intermédiaire (34).

**7.** Résonateur selon l'une quelconque des revendications 1 à 4, dans lequel

- la structure résonante comporte un matériau piézoélectrique ;
- le résonateur comporte deux électrodes d'actionnement ($38_i$, $38_s$), de part et d'autre de la structure résonante, les électrodes d'actionnement formant l'actionneur.

8. Résonateur selon l'une quelconque des revendications précédentes, dans lequel la structure résonante et le guide d'onde périphérique sont formés du même matériau.

9. Résonateur selon l'une quelconque des revendications précédentes, dans lequel la structure résonante a une forme cylindrique, à base circulaire ou polygonale, ou annulaire.

10. Résonateur selon l'une quelconque des revendications précédentes, dans lequel la fréquence de résonance est supérieure à 1 MHz.

11. Oscillateur opto-mécanique, comportant :

- une source de lumière (10), configurée pour émettre un faisceau lumineux et propager ce dernier le long d'un résonateur (30);
- le résonateur étant configuré de façon que l'oscillation périodique du résonateur entraîne une modulation périodique d'une puissance lumineuse du faisceau de lumineux ;
- l'oscillateur opto-mécanique étant **caractérisé en ce que** le résonateur est un résonateur selon l'une quelconque des revendications précédentes.

**Fig. 1A**

**Fig 1B**

**Fig. 2**

**Fig. 3A**

**Fig. 3B**

**Fig. 3C**

**Fig. 3D**

**Fig. 4**

**Fig. 5A**

**Fig. 5B**

**Fig. 6A**

**Fig. 6B**

**Fig. 6C**

43c

44

43a

43b

43c

43b

43a

41

**Fig. 6D**

43c

44

43a

43b

43c

43b

43a

41

**Fig. 6E**

43c

44  43a

43a

43b

43c

43b

41

**Fig. 6F**

Fig. 6G

Fig. 6H

Fig. 6I

**Fig. 7**

Europäisches
Patentamt

European
Patent Office

Office européen
des brevets

# RAPPORT DE RECHERCHE EUROPEENNE

Numéro de la demande

EP 25 15 0820

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/224606 A1 (BOWEN WARWICK [AU] ET AL) 9 août 2018 (2018-08-09) | 1,4-6, 8-11 | INV. G02F1/01 F21V8/00 |
| Y | * abrégé; revendication 16; figures 1-5 * * alinéas [0003], [0042] - [0053], [0067] * | 2,3,7 | |
| Y | US 2019/101488 A1 (VIROT LEOPOLD [FR] ET AL) 4 avril 2019 (2019-04-04) * abrégé; revendications 7,14-17; figures 1a,2a * * alinéas [0048], [0052], [0058], [0106] * | 2,3,7 | |
| A | US 2022/334314 A1 (HENTZ SÉBASTIEN [FR] ET AL) 20 octobre 2022 (2022-10-20) * abrégé; revendication 1; figures 1,2 * * alinéas [0068] - [0087] * | 1-11 | |
| A | US 2015/107357 A1 (HENTZ SÉBASTIEN [FR] ET AL) 23 avril 2015 (2015-04-23) * abrégé; figures 3,4 * * alinéas [0045], [0070] - [0074] * | 1-11 | |
| A | US 2012/294564 A1 (BHAVE SUNIL [US] ET AL) 22 novembre 2012 (2012-11-22) * abrégé; figures 1,2,8,9 * * alinéa [0083]; revendication 1 * | 1-11 | |

DOMAINES TECHNIQUES
RECHERCHES (IPC)

G02F
G02B

Le présent rapport a été établi pour toutes les revendications

| Lieu de la recherche | Date d'achèvement de la recherche | Examinateur |
|---|---|---|
| La Haye | 29 janvier 2025 | Beugin, Anne |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 15 0820

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-01-2025

| Document brevet cité au rapport de recherche | Date de publication | Membre(s) de la famille de brevet(s) | Date de publication |
|---|---|---|---|
| US 2018224606 A1 | 09-08-2018 | US 2018224606 A1 | 09-08-2018 |
| | | WO 2017011872 A1 | 26-01-2017 |
| US 2019101488 A1 | 04-04-2019 | EP 3462145 A1 | 03-04-2019 |
| | | FR 3071923 A1 | 05-04-2019 |
| | | US 2019101488 A1 | 04-04-2019 |
| US 2022334314 A1 | 20-10-2022 | EP 4089452 A1 | 16-11-2022 |
| | | FR 3121924 A1 | 21-10-2022 |
| | | US 2022334314 A1 | 20-10-2022 |
| US 2015107357 A1 | 23-04-2015 | CN 104579224 A | 29-04-2015 |
| | | EP 2866000 A1 | 29-04-2015 |
| | | US 2015107357 A1 | 23-04-2015 |
| US 2012294564 A1 | 22-11-2012 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- US 2018224606 A
- US 2019101488 A
- US 2022334314 A

**Littérature non-brevet citée dans la description**

- **BEYAZOGLU et al.** *A multimaterial Q-boosted low phase noise optomechanical oscillator*